# EUROPEAN PATENT SPECIFICATION

(11) **EP 4 485 040 B1**
(45) Date of publication and mention of the grant of the patent: **21.10.2026**
(21) Application number: 23777987.1
(22) Date of filing: 23.03.2023
(51) Int. Cl.: G02B 26/08, G02B 26/10, B81B 3/00, G01S 7/481

(54) **ELECTROMAGNETIC GALVANOMETER AND GALVANOMETER SYSTEM**
ELEKTROMAGNETISCHES GALVANOMETER UND GALVANOMETERSYSTEM
GALVANOMÈTRE ÉLECTROMAGNÉTIQUE ET SYSTÈME DE GALVANOMÈTRE

(30) Priority: 30.03.2022 CN 202210334320
(43) Date of publication of application: 01.01.2025
(73) Proprietor: Huawei Technologies Co., Ltd., Shenzhen, Guangdong 518129 (CN)
(72) Inventor: DONG, Xiaoshi, Shenzhen, Guangdong 518129 (CN); XU, Jinghui, Shenzhen, Guangdong 518129 (CN); ZHAO, Fei, Shenzhen, Guangdong 518129 (CN)
(74) Representative: MERH-IP Matias Erny Reichl Hoffmann Patentanwälte PartG mbB
(86) International application number: PCT/CN2023/083330
(87) International publication number: WO 2023/185617

(56) References cited:
- WO-A1-2022/162828
- CN-A- 108 474 941
- CN-A- 108 474 941
- CN-A- 108 535 861
- CN-A- 110 726 984
- CN-A- 113 805 158
- JP-A- 2003 207 737
- JP-A- 2019 184 858
- US-A1- 2008 198 433
- US-A1- 2016 122 178

## Description

This application claims priority to Chinese Patent Application No. 202210334320.5, filed on March 30, 2022 and entitled "ELECTROMAGNETIC MICROMIRROR AND MICROMIRROR SYSTEM".

### TECHNICAL FIELD

This application relates to the field of micromirror technologies, and in particular, to an electromagnetic micromirror and a micromirror system.

### BACKGROUND

An electromagnetic micromirror is a device that drives a reflector to move by electromagnetic force.

The electromagnetic micromirror usually includes a movable part, a support beam, and a fastened part. The movable part includes a framework, and the reflector and an electromagnetic coil that are located on the framework. The electromagnetic coil is configured to drive the reflector to move. The reflector has a reflective surface that backs onto the framework. The fastened part includes a fastened plate and an electrode located on the fastened plate. The framework is connected to the fastened plate via the support beam, and the electromagnetic coil on the framework is connected to the electrode on the fastened plate via a routed wire on the support beam. When a drive electrical signal is input to the electrode, the drive electrical signal can reach the electromagnetic coil along the routed wire on the support beam. The electromagnetic coil generates electromagnetic force motion under an action of the drive electrical signal, and drives a portion (for example, the reflector) in the movable part other than the electromagnetic coil to move.

However, when the movable part moves, stress on the support beam is high, and the routed wire on the support beam is prone to breakage under impact of the stress. As a result, the electromagnetic micromirror cannot be used.
Document CN 108 474 941 A generally discloses an actuator device with: a support part; a moveable part; a coupling part that couples the moveable part to the support part on a second axis line such that the moveable part can be oscillated around the second axis line; a first wiring provided on the coupling part; and a second wiring provided on the support part. A first metal material that constitutes the first wiring has a higher rigidity than a second metal material that constitutes the second wiring. The second wiring is connected to a surface of a first connection portion, the surface being on the opposite side of the support part at the first connection portion located on the support part.
Document US 2008/198433 A1 generally discloses an optical scanner including a mirror part for reflecting light, a main axis part for supporting the mirror part in a pivotable manner, and a deformable holding part for holding the main axis part. A torsion bar for converting a deformation of the holding part itself into a deformation in torsion is disposed adjacent to the main axis part and is formed in at least one of the holding part and the mirror part. The deformation in torsion generated in the torsion bar makes the mirror part tilt.

### SUMMARY

This application provides an electromagnetic micromirror and a micromirror system, to resolve a problem that a routed wire is prone to breakage. In particular, this application provides an electromagnetic micromirror having the features of claim 1. The dependent claims relate to preferred embodiments. Content is as follows.

According to a first aspect, an electromagnetic micromirror is provided, including a movable part, a fastened part, and a first support part. The movable part includes a framework, and a reflector and a first electromagnetic coil that are located on the framework. The fastened part includes a fastened plate and a first electrode located on the fastened plate. The first support part includes a first support structure and a second support structure that are spaced from each other. In the movable part, the first electromagnetic coil is configured to drive the reflector to move. The reflector has a reflective surface that backs onto the framework. In the first support part, both the first support structure and the second support structure connect the framework to the fastened plate, and rigidity of the first support structure is higher than rigidity of the second support structure. The second support structure has a first routed wire that connects the first electrode to the first electromagnetic coil.

In the electromagnetic micromirror provided in this application, the framework and the fastened plate are connected to each other via the first support structure and the second support structure, and the rigidity of the first support structure is higher than the rigidity of the second support structure. In addition, the first routed wire that connects the first electrode to the first electromagnetic coil is disposed on the second support structure with lower rigidity. In this way, because stress of the second support structure is lower, when the movable part moves, a risk that the first routed wire is broken under an action of the stress of the support structure can be reduced. In addition, because the rigidity of the first support structure is higher, under an action of the first support structure, a stable connection between the framework and the fastened part can be ensured, to ensure reliability of the electromagnetic micromirror.

It can be learned from the foregoing content that the rigidity of the first support structure is higher than the rigidity of the second support structure. In an implementation, both the first support structure and the second support structure are in a line shape (slender shape), and a magnitude relationship between rigidity of support structures may be implemented using a value relationship between equivalent lengths and equivalent widths of the support structures. For example, an equivalent length of the first support structure is less than an equivalent length of the second support structure, and an equivalent width of the first support structure is greater than an equivalent width of the second support structure. For example, twice the equivalent length of the first support structure is less than the equivalent length of the second support structure. Certainly, alternatively, the first support structure and the second support structure may not be in a line shape, and may be, for example, in a plane shape (for example, a rectangular-plane shape or a circular-plane shape).

It should be noted that, for each support structure in the first support structure and the second support structure, the line shape of the support structure may be a straight-line shape, a curvilinear shape, a broken-line shape, or the like. For example, the first support structure is in the straight-line shape, and/or the second support structure is in a serpentine shape (for example, a broken-line serpentine shape or a curvilinear serpentine shape (for example, an S shape)). An equivalent length of a support structure is a length obtained when a line shape of the support structure is extended to be a straight line. An equivalent width of a support structure is a width obtained when a line shape of the support structure is extended to be a straight line.

A material of the first support structure and a material of the second support structure are not limited in this application. The material of the first support structure may be the same as or different from the material of the second support structure. In this application, for example, materials of the first support structure, the second support structure, and the framework are the same. In this case, a same material layer may be processed, to produce and obtain the first support structure, the second support structure, and the framework at the same time. When the material of the first support structure is different from the material of the second support structure, rigidity of the material of the first support structure may be higher than, equal to, or lower than rigidity of the material of the second support structure.

In addition, alternatively, a magnitude relationship between rigidity of support structures may not be implemented using a value relationship between equivalent lengths and equivalent widths of the support structures. For example, the magnitude relationship between the rigidity of the support structures may be implemented using different materials of the support structures.

Further, there are various quantities and arrangement locations of first support structures and second support structures in the first support part of the electromagnetic micromirror. For example, the first support part includes the first support structure and two groups of second support structures located on two sides of the first support structure; and one group of second support structures may include at least one second support structure. For another example, alternatively, the first support part may not include the first support structure and two groups of second support structures located on two sides of the first support structure, but includes the second support structure and two groups of first support structures located on two sides of the second support structure; and one group of first support structures may include at least one first support structure.

Further, regardless of how the first support structure and the second support structure are arranged, there may be a correspondence between the first electrode on the fastened plate of the electromagnetic micromirror and the second support structure. For example, when the electromagnetic micromirror includes a plurality of second support structures, the fastened plate has a plurality of first electrodes that are in one-to-one correspondence with the plurality of second support structures, and first routed wires on the second support structures are connected to the first electrodes corresponding to the second support structures.

Further, the electromagnetic micromirror may include one first support part, or may include a plurality of first support parts. This is not limited in this application. For example, the electromagnetic micromirror includes two groups of first support parts located on two opposite sides of the reflector. One group of first support parts may include one or more first support parts. In addition, when the electromagnetic micromirror includes the plurality of first support parts, the plurality of first support parts may include different first support parts, or the plurality of first support parts are all the same.

Regardless of a quantity of first support parts included in the electromagnetic micromirror, the fastened part may include one or more fastened plates. For example, when the electromagnetic micromirror includes the two groups of first support parts located on the two opposite sides of the reflector, the fastened part includes two fastened plates that are in one-to-one correspondence with the two groups of first support parts. For one first support part in one group of first support parts that corresponds to one fastened plate, the first support part is located between the fastened plate and the reflector, both a first support structure and a second support structure in the first support part are connected to the fastened plate, and a first routed wire on the second support structure is connected to a first electrode on the fastened plate.

Further, the framework may be in a solid plate shape. The reflector and the first electromagnetic coil are located on the framework. Optionally, the framework may alternatively be implemented in another manner. For example, the framework includes a first inner frame, a second support part, and a first outer frame. The first outer frame surrounds the first inner frame, and is spaced from the first inner frame. The reflector is located on the first inner frame. The first electromagnetic coil is located on the first outer frame. The first support part is connected to the first outer frame. The second support part is located between the first outer frame and the first inner frame, and connects the first outer frame to the first inner frame. A first hollow area exists between the first outer frame and the first inner frame. The first support part and the second support part are located in different orientations of the reflector.

When the framework includes the first inner frame, the second support part, and the first outer frame, the first electromagnetic coil may be driven, by changing a drive electrical signal loaded on the first electrode, to drive the reflector to perform different motion (for example, rotate around different rotation axes).

Further, when the framework includes the first inner frame, the second support part, and the first outer frame, the movable part further includes a second electromagnetic coil. The second electromagnetic coil is located on the first inner frame, and is configured to drive the reflector to move. For example, the second electromagnetic coil and the reflector may be located on a same side of the framework, the second electromagnetic coil surrounds the reflector, and the second electromagnetic coil and the reflector are spaced from each other. For another example, alternatively, the second electromagnetic coil and the reflector may not be located on a same side of the framework, but are located on two opposite sides of the framework.

The second support part includes a third support structure and a fourth support structure. Both the third support structure and the fourth support structure connect the first outer frame to the first inner frame. Rigidity of the third support structure is higher than rigidity of the fourth support structure. In this case, the fastened part further includes a second electrode located on the fastened plate. The fourth support structure, the first outer frame, and the second support structure have a second routed wire that connects the second electrode to the second electromagnetic coil. The second routed wire is insulated from the first routed wire. When the movable part includes the first electromagnetic coil and the second electromagnetic coil, drive electrical signals may be loaded to different electromagnetic coils through different electrodes, so that different electromagnetic coils drive the reflector to perform different motion (for example, rotate around different rotation axes).

In addition, similar to that the first support part includes the first support structure with higher rigidity and the second support structure with the lower rigidity, the second support part also includes the third support structure with higher rigidity and the fourth support structure with lower rigidity. The second routed wire is located on the fourth support structure. In this way, because stress of the fourth support structure is lower, when the reflector moves, a risk that the second routed wire is broken under an action of the stress of the support structure can be reduced. In addition, because the rigidity of the third support structure is higher, under an action of the third support structure, a stable connection between the first outer frame and the first inner frame can be ensured, to ensure reliability of the electromagnetic micromirror.

For a shape, a material, an arrangement location, and the like of the third support structure, refer to those of the first support structure. For a shape, a material, an arrangement location, and the like of the fourth support structure, refer to those of the second support structure.

For example, both the third support structure and the fourth support structure are also in the line shape, an equivalent length of the third support structure is less than an equivalent length of the fourth support structure, and an equivalent width of the third support structure is greater than an equivalent width of the fourth support structure. For example, twice the equivalent length of the third support structure is less than the equivalent length of the fourth support structure. The third support structure may be in the straight-line shape, and/or the fourth support structure may be in the serpentine shape. Materials of the third support structure, the fourth support structure, the first inner frame, and the first outer frame may be the same. The second support part may include the third support structure and two groups of fourth support structures located on two sides of the third support structure. Alternatively, the second support part may include the fourth support structure and two groups of third support structures located on two sides of the fourth support structure. The fastened plate may have a plurality of second electrodes. The second support part may include a plurality of fourth support structures that are in one-to-one correspondence with the plurality of second electrodes. Second routed wires on the fourth support structures are connected to the second electrodes corresponding to the fourth support structures. The electromagnetic micromirror may include two groups of second support parts located on two opposite sides of the reflector. When the electromagnetic micromirror includes a plurality of second support parts, the plurality of second support parts may include different second support parts, or the plurality of second support parts may be the same.

Further, in this application, the electromagnetic micromirror may include the first routed wire, or the first routed wire and the second routed wire. For any routed wire (for example, the first routed wire or the second routed wire) in the electromagnetic micromirror, the routed wire may meet any one of the following four conditions.

Condition 1: The routed wire may be in contact with a component on which the routed wire is located. A component on which the first routed wire is located may be the second support structure. A component on which the second routed wire is located may be the fourth support structure, the first outer frame, and/or the second support structure.

Condition 2: A first insulation layer exists between the routed wire and a component on which the routed wire is located. For example, a first insulation layer exists between the first routed wire and the second support structure.

Condition 3: The routed wire includes a plurality of sub-wires connected in parallel, and orthographic projections of the plurality of sub-wires on a component on which the routed wire is located are spaced from each other. For example, the first routed wire includes two sub-wires, the two sub-wires are located at a same layer, and are both in contact with the second support structure, and the two sub-wires are insulated from each other. Alternatively, the first routed wire includes two sub-wires, the two sub-wires are located at a same layer, a first insulation layer exists between each of the two sub-wires and the second support structure, and the two sub-wires are insulated from each other.

Condition 4: The routed wire includes a plurality of sub-wires connected in parallel, orthographic projections of the plurality of sub-wires on a component on which the routed wire is located at least partially overlap, and the routed wire further includes a second insulation layer located between the plurality of sub-wires. For example, the first routed wire includes two sub-wires, the two sub-wires are located and stacked on the second support structure, and a second insulation layer exists between the two sub-wires.

Certainly, the routed wire may alternatively be implemented in another manner. Examples are not provided one by one herein in this application.

Optionally, materials of the fastened plate, the first support structure, the second support structure, and the framework are the same. In this way, a same material layer may be processed, to produce and obtain the fastened plate, the first support structure, the second support structure, and the framework at the same time.

Optionally, materials of the reflector, the routed wire (for example, the first routed wire, or the first routed wire and the second routed wire) in the electromagnetic micromirror, and an electrode (for example, the first electrode, or the first electrode and) in the electromagnetic micromirror are the same. In this way, a same material layer may be processed, to produce and obtain the reflector, and the routed wire and the electrode in the electromagnetic micromirror at the same time. For example, the first routed wire and the second routed wire in this application may be a conductive material like metal.

Further, a portion in the electromagnetic micromirror provided in this application other than an electromagnetic coil may be an axisymmetric structure (or an approximately axisymmetric structure) or a non-axisymmetric structure. For example, an orthographic projection of the portion in the electromagnetic micromirror other than the electromagnetic coil on a reference plane parallel to the reflector is an axisymmetric pattern (or an approximately axisymmetric pattern). The axisymmetric pattern has at least one of a first symmetry axis and a second symmetry axis. The first symmetry axis and the second symmetry axis are perpendicular and both pass through a center of an orthographic projection of the reflector on the reference plane.

According to a second aspect, a micromirror system is provided, including a drive unit and the electromagnetic micromirror according to any design of the first aspect. The drive unit is connected to an electrode in the electromagnetic micromirror, and is configured to provide a drive electrical signal for the electrode, to drive a movable part in the electromagnetic micromirror to move.

Further, the micromirror system provided in this application further includes a second inner frame, a connection part, and a second outer frame that correspond to the electromagnetic micromirror. A whole including the second inner frame, the connection part, and the second outer frame may be referred to as a backup plate. The second inner frame may be an insulation material, a conductive material, or a magnet. This is not limited in this application. The second outer frame surrounds the second inner frame. The second outer frame and the second inner frame are spaced from each other. The connection part is between the second outer frame and the second inner frame, and connects the second outer frame to the second inner frame. A second hollow area exists between the second outer frame and the second inner frame. A fastened plate is fastened to the second inner frame.

When the micromirror system includes the second inner frame, the connection part, and the second outer frame, the connection part and the second hollow area exist between the second inner frame and the second outer frame. When the electromagnetic micromirror is packaged, the fastened part may be fastened to the second inner frame in a manner like an adhesive, bonding, or soldering. In this case, under an action of the connection part and the second hollow area, stress applied to the fastened part is low. Therefore, packaging stress of the electromagnetic micromirror is reduced, impact of the packaging stress on the electromagnetic micromirror is reduced, and performance of the electromagnetic micromirror is improved.

Optionally, materials of the second inner frame, the connection part, and the second outer frame are the same. In this way, a same material layer may be processed, to produce and obtain the second inner frame, the connection part, and the second outer frame at the same time.

Optionally, the connection part may be in various shapes. This is not limited in this application. For example, the connection part may also be in a line shape (for example, a straight-line shape, a curvilinear shape, a broken-line shape, or a serpentine shape), and an extension direction of the connection part may be parallel to or perpendicular to an arrangement direction of the second inner frame and the second outer frame. In addition, to further reduce the packaging stress applied to the electromagnetic micromirror, when the connection part may also be in the linear shape, an equivalent length of the connection part may be greater than a spacing between the second outer frame and the second inner frame. Certainly, the equivalent length of the connection part may alternatively be equal to the spacing. This is not limited in this application.

Further, an orthographic projection of the first support part on a reference plane parallel to a reflector and an orthographic projection of the second inner frame on the reference plane may at least partially overlap. Before delivery of the electromagnetic micromirror, the electromagnetic micromirror needs to be shaken, to perform a reliability test on the electromagnetic micromirror. However, in a process of shaking the electromagnetic micromirror, a support beam is prone to breakage, and therefore the electromagnetic micromirror cannot be used, resulting in low reliability of the electromagnetic micromirror. In the micromirror system provided in this application, the orthographic projection of the first support part on the reference plane parallel to the reflector and the orthographic projection of the second inner frame on the reference plane at least partially overlap. Therefore, at least a partial area in the first support part can be supported by the second inner frame. When the reliability test is performed on the electromagnetic micromirror, under a support action of the second inner frame, force applied to the first support part can be buffered on the second inner frame. This can reduce a risk that the first support part is broken, thereby improving reliability of the electromagnetic micromirror.

There may be a plurality of implementations in which the orthographic projection of the first support part on the reference plane parallel to the reflector and the orthographic projection of the second inner frame on the reference plane at least partially overlap. For example, in an optional implementation, the second inner frame includes an inner frame part and a stop part that are connected to each other. The inner frame part may surround the stop part. The fastened plate is fastened to the inner frame part. At least a partial orthographic projection of the first support part on the reference plane and an orthographic projection of the stop part on the reference plane at least partially overlap. In this case, the stop part is configured to support the first support part when the reliability test is performed on the electromagnetic micromirror. For example, an orthographic projection, on the reference plane, of a portion that is of the stop part and that protrudes from the inner frame part may be in the line shape.

Further, in a thickness direction of the second inner frame, a thickness of the stop part is less than a thickness of the inner frame part. In this way, elasticity of the stop part can be improved, mechanical rigidity of the stop part can be reduced, and an effect of buffering, on the stop part, the force applied to the first support part can be improved. Certainly, a thickness of the stop part may alternatively be greater than or equal to a thickness of the inner frame part. This is not limited in this application.

In the foregoing descriptions, an example in which the micromirror system includes one electromagnetic micromirror is used. Optionally, the micromirror system may alternatively include a plurality of electromagnetic micromirrors. The plurality of electromagnetic micromirrors may be the same, or the plurality of electromagnetic micromirrors may include different electromagnetic micromirrors.

For example, when the micromirror system includes the plurality of electromagnetic micromirrors, the plurality of electromagnetic micromirrors may be arranged in an array or may not be arranged in an array. For example, when the electromagnetic micromirror includes two groups of first support parts located on two opposite sides of the reflector, a row direction or a column direction of the plurality of electromagnetic micromirrors is an arrangement direction of the two groups of first support parts.

In addition, a whole including the electromagnetic micromirror, the second inner frame, the connection part, and the second outer frame in the micromirror system provided in this application may also be an axisymmetric structure (or an approximately axisymmetric structure) or a non-axisymmetric structure. For example, an orthographic projection of the whole on the reference plane parallel to the reflector is an axisymmetric pattern (or an approximately axisymmetric pattern), and the axisymmetric pattern also has at least one of the first symmetry axis and the second symmetry axis.

The micromirror system provided in this application may further include a light source, and/or a receiving unit and a processing unit. Optionally, the micromirror system may not include a light source, a receiving unit, and a processing unit. The light source is configured to emit light (for example, laser) to the reflector in the electromagnetic micromirror. In this case, the reflector is configured to reflect received light. For example, the reflector is configured to reflect the received light in a moving process. The receiving unit is configured to: receive light that is reflected by the reflector after being reflected by an object, and provide an electrical signal of the object for the processing unit based on the received light. The processing unit is configured to output scanning information of the object (for example, a two-dimensional image or a three-dimensional image of the object) based on the received electrical signal of the object.

For effects of the second aspect, refer to corresponding effects in the first aspect. Details are not described herein in this application.

### BRIEF DESCRIPTION OF DRAWINGS

FIG. 1 is a diagram of a structure of an electromagnetic micromirror according to an embodiment of this application;
FIG. 2 is a diagram of a structure of another electromagnetic micromirror according to an embodiment of this application;
FIG. 3 is a diagram of a structure of another electromagnetic micromirror according to an embodiment of this application;
FIG. 4 is a diagram of a structure of another electromagnetic micromirror according to an embodiment of this application;
FIG. 5 is a diagram of a structure of another electromagnetic micromirror according to an embodiment of this application;
FIG. 6 is a diagram of a structure of another electromagnetic micromirror according to an embodiment of this application;
FIG. 7 is a diagram of a structure of another electromagnetic micromirror according to an embodiment of this application;
FIG. 8 is a diagram of a cross section of any location that is on a second support structure in FIG. 1 and at which a first routed wire is disposed;
FIG. 9 is a diagram of another cross section of any location that is on a second support structure in FIG. 1 and at which a first routed wire is disposed;
FIG. 10 is a diagram of another cross section of any location that is on a second support structure in FIG. 1 and at which a first routed wire is disposed;
FIG. 11 is a diagram of another cross section of any location that is on a second support structure in FIG. 1 and at which a first routed wire is disposed;
FIG. 12 is a diagram of another cross section of any location that is on a second support structure in FIG. 1 and at which a first routed wire is disposed;
FIG. 13 is a diagram of a structure of a micromirror system according to an embodiment of this application;
FIG. 14 is a diagram of a structure of another micromirror system according to an embodiment of this application;
FIG. 15 is a diagram of a structure of another micromirror system according to an embodiment of this application;
FIG. 16 is a diagram of a structure of another micromirror system according to an embodiment of this application;
FIG. 17 is a diagram of a structure of another micromirror system according to an embodiment of this application;
FIG. 18 is a diagram of a structure of another micromirror system according to an embodiment of this application; and
FIG. 19 is a diagram of a structure of another micromirror system according to an embodiment of this application.

### DESCRIPTION OF EMBODIMENTS

To make principles and technical solutions of this application clearer, the following further describes implementations of this application in detail with reference to the accompanying drawings.

An electromagnetic micromirror is a device that drives a reflector to move by electromagnetic force. The electromagnetic micromirror may be used in a micromirror system including an electromagnetic micromirror, for example, an optical system (for example, a lidar (for example, a lidar used in a driverless vehicle), a projector, or a microprojector) or a micromirror. A driving mode of a micromirror may be classified into electrostatic driving, magnetoelectric driving, piezoelectric driving, thermoelectric driving, and the like. A driving mode of the electromagnetic micromirror is the magnetoelectric driving mode. The magnetoelectric driving mode has larger driving force, and is a preferred solution for a large-aperture micromirror system (for example, a large-aperture lidar). In addition, when the electromagnetic micromirror is used as a laser beam scanning element, the micromirror system has advantages such as a small size, a simple structure, high reliability, and low power consumption.

The electromagnetic micromirror usually includes a movable part, a support beam, and a fastened part. The movable part includes a framework, and the reflector and an electromagnetic coil that are located on the framework. The electromagnetic coil is configured to drive the reflector to move. The reflector has a reflective surface that backs onto the framework. The fastened part includes a fastened plate and an electrode located on the fastened plate. The framework is connected to the fastened plate via the support beam, and the electromagnetic coil on the framework is connected to the electrode on the fastened plate via a routed wire on the support beam. When a drive electrical signal is input to the electrode, the drive electrical signal can reach the electromagnetic coil along the routed wire on the support beam. The electromagnetic coil generates electromagnetic force motion under an action of the drive electrical signal, and drives a portion (for example, the reflector) in the movable part other than the electromagnetic coil to move (for example, shift or rotate). However, when the movable part moves, stress on the support beam is high, and the routed wire on the support beam is prone to breakage under impact of the stress. As a result, the electromagnetic micromirror cannot be used, and a service life of the electromagnetic micromirror is reduced. How to improve the service life of the electromagnetic micromirror and reduce the stress on the support beam is one of problems that need to be resolved.

In addition, in a process of packaging the electromagnetic micromirror, the movable part, the support beam, and the fastened part usually need to be bonded to a substrate (also referred to as a backup plate) by using glue. A thermal mismatch between the glue and the movable part, the support beam, the fastened part, and the substrate causes high packaging stress on the movable part, the support beam, and the fastened part. Such packaging stress also affects performance such as a resonant frequency and an angle capability of the electromagnetic micromirror. Therefore, how to reduce impact of the packaging stress of the electromagnetic micromirror on the electromagnetic micromirror is another problem that needs to be resolved.

In addition, before delivery of the electromagnetic micromirror, the electromagnetic micromirror needs to be shaken, to perform a reliability test on the electromagnetic micromirror. However, in a process of shaking the electromagnetic micromirror, the support beam is prone to breakage, and therefore the electromagnetic micromirror cannot be used, resulting in low reliability of the electromagnetic micromirror.

Based on the foregoing problems, embodiments of this application provide an electromagnetic micromirror. Stress on a support beam in the electromagnetic micromirror is low, and the electromagnetic micromirror is also less affected by packaging stress. A probability that the electromagnetic micromirror cannot be used after a reliability test is low, improving reliability of the electromagnetic micromirror.

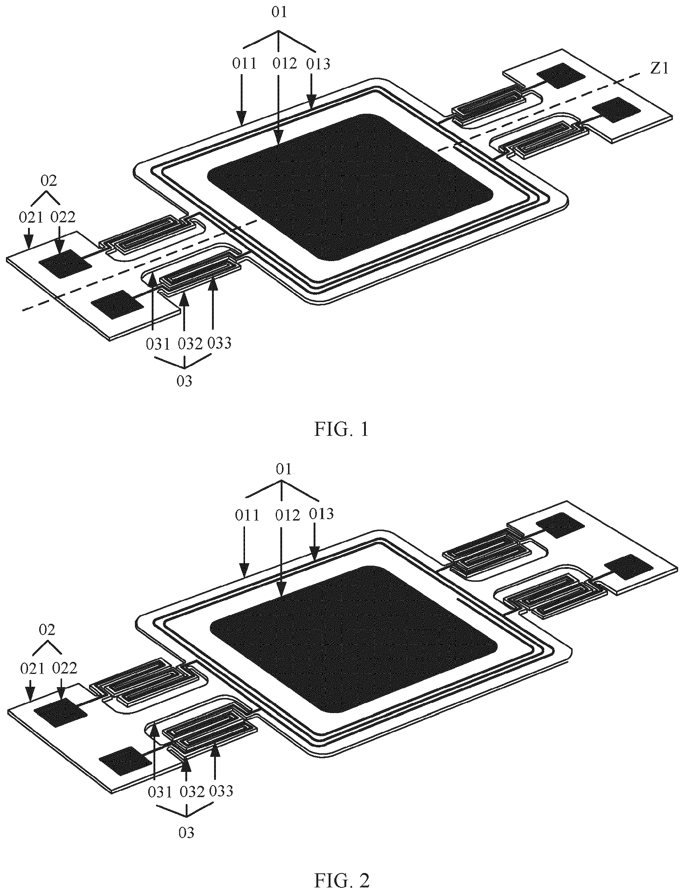

For example, FIG. 1 is a diagram of a structure of an electromagnetic micromirror according to an embodiment of this application. As shown in FIG. 1, the electromagnetic micromirror includes a movable part 01, a fastened part 02, and a first support part 03.

The movable part 01 includes a framework 011, and a reflector 012 and a first electromagnetic coil 013 that are located on the framework 011. The first electromagnetic coil 013 is configured to drive the reflector 012 to move (for example, shift or rotate). For example, the first electromagnetic coil 013 and the reflector 012 are located on a same side of the framework 011, the first electromagnetic coil 013 surrounds the reflector 012, and the first electromagnetic coil 013 and the reflector 012 are spaced from each other. For another example, alternatively, the first electromagnetic coil 013 and the reflector 012 may not be located on a same side of the framework 011, but are located on two opposite sides of the framework 011. The reflector 012 has a reflective surface that is away from the framework 011. A surface of the reflector 012 other than a surface that is away from the framework 011 may be a reflective surface or may not be a reflective surface. This is not limited in embodiments of this application.

The fastened part 02 includes a fastened plate 021 and a first electrode 022 located on the fastened plate 021.

The first support part 03 includes a first support structure 031 and a second support structure 032 that are spaced from each other. Both the first support structure 031 and the second support structure 032 connect the framework 011 to the fastened plate 021. Rigidity of the first support structure 031 is higher than rigidity of the second support structure 032. The second support structure 032 has a first routed wire 033 that connects the first electrode 022 to the first electromagnetic coil 013.

When a drive electrical signal is loaded on the first electrode 022, the first electromagnetic coil 013 can move, and drive a portion (for example, the reflector 012) in the entire movable part other than the first electromagnetic coil 013 to move (for example, rotate). When the reflector 012 rotates under driving of the first electromagnetic coil 013, a rotation axis of the reflector 012 is parallel to an arrangement direction of the reflector 012 and the first support part 03. For example, the rotation axis may be a rotation axis Z1 in FIG. 1.

It should be noted that, in this embodiment of this application, an example in which the electromagnetic coil is configured to drive the reflector to rotate is used. When the electromagnetic coil is not configured to drive the reflector to rotate, an arrangement manner of the electromagnetic coil and the reflector may be different from an arrangement manner in the accompanying drawings. This is not limited in embodiments of this application.

**In** conclusion, in the electromagnetic micromirror provided in this embodiment of this application, the framework and the fastened plate are connected to each other via the first support structure and the second support structure, and the rigidity of the first support structure is higher than the rigidity of the second support structure. In addition, the first routed wire that connects the first electrode to the first electromagnetic coil is disposed on the second support structure with lower rigidity. In this way, because stress of the second support structure is lower, when the movable part moves, a risk that the first routed wire is broken under an action of the stress of the support structure can be reduced. In addition, because the rigidity of the first support structure is higher, under an action of the first support structure, a stable connection between the framework and the fastened part can be ensured, to ensure reliability of the electromagnetic micromirror.

The following describes each portion in the electromagnetic micromirror.

It can be learned from the foregoing embodiment that the rigidity of the first support structure 031 is higher than the rigidity of the second support structure 032. In an implementation, both the first support structure 031 and the second support structure 032 are in a line shape (slender shape), and a magnitude relationship between rigidity of support structures may be implemented using a value relationship between equivalent lengths and equivalent widths of the support structures. For example, an equivalent length of the first support structure 031 is less than an equivalent length of the second support structure 032, and an equivalent width of the first support structure 031 is greater than an equivalent width of the second support structure 032. For example, twice the equivalent length of the first support structure 031 is less than the equivalent length of the second support structure 032. Certainly, alternatively, the first support structure 031 and the second support structure 032 may not be in a line shape, and may be, for example, in a plane shape (for example, a rectangular-plane shape or a circular-plane shape).

It should be noted that, for each support structure in the first support structure 031 and the second support structure 032, the line shape of the support structure may be a straight-line shape, a curvilinear shape, a broken-line shape, or the like. For example, the first support structure 031 is in the straight-line shape, and/or the second support structure 032 is in a serpentine shape (for example, a broken-line serpentine shape or a curvilinear serpentine shape (for example, an S shape)). An equivalent length of a support structure is a length obtained when a line shape of the support structure is extended to be a straight line. An equivalent width of a support structure is a width obtained when a line shape of the support structure is extended to be a straight line.

When the second support structure 032 is in the broken-line serpentine shape, the second support structure 032 includes a plurality of support beams that are sequentially arranged (for example, sequentially and periodically arranged) in an extension direction of the second support structure 032, and at least one connection beam that is configured to sequentially connect the plurality of support beams end to end. In FIG. 1, for example, the second support structure 032 includes three support beams. Optionally, the second support structure 032 may alternatively include more support beams. For example, as shown in FIG. 2, the second support structure 032 may alternatively include five support beams.

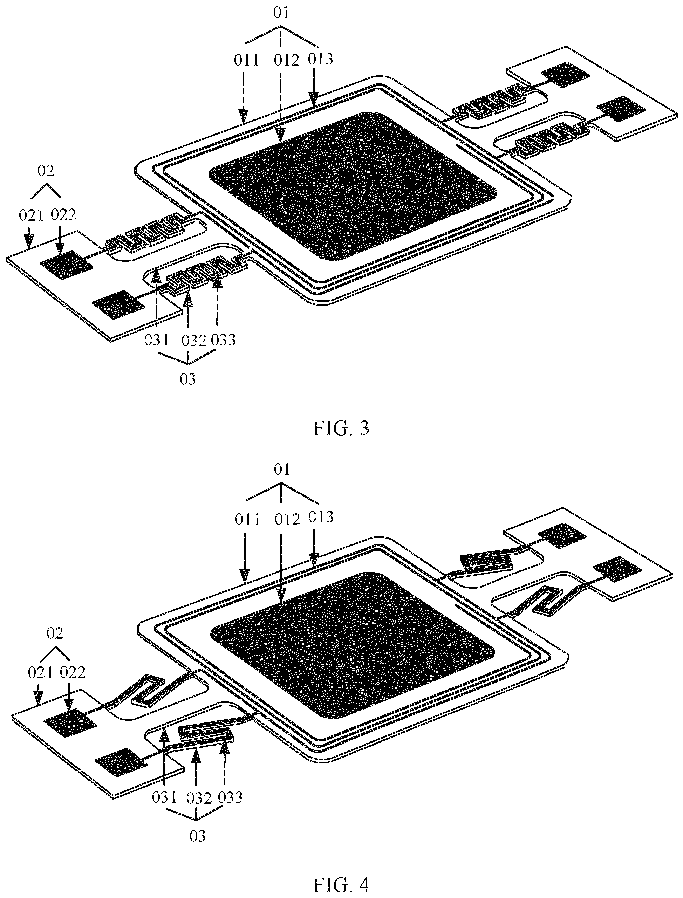

Further, in this embodiment of this application, an example in which the second support structure 032 is in the serpentine shape is used. In this case, the extension direction of the second support structure 032 may be perpendicular to an arrangement direction of the reflector 012 and the fastened plate 021, as shown in FIG. 1 or FIG. 2. Certainly, alternatively, the extension direction may not be perpendicular to the arrangement direction. For example, as shown in FIG. 3, the extension direction is parallel to the arrangement direction, or as shown in FIG. 4, an included angle between the extension direction and the arrangement direction is greater than 0 degrees and less than 90 degrees (in FIG. 4, for example, the included angle is 45 degrees).

A material of the first support structure 031 and a material of the second support structure 032 are not limited in embodiments of this application. The material of the first support structure 031 may be the same as or different from the material of the second support structure 032. In this embodiment of this application, for example, materials of the first support structure 031, the second support structure 032, and the framework 011 are the same. In this case, a same material layer may be processed, to produce and obtain the first support structure 031, the second support structure 032, and the framework 011 at the same time. When the material of the first support structure 031 is different from the material of the second support structure 032, rigidity of the material of the first support structure 031 may be higher than, equal to, or lower than rigidity of the material of the second support structure 032.

In addition, alternatively, a magnitude relationship between rigidity of support structures may not be implemented using a value relationship between equivalent lengths and equivalent widths of the support structures. For example, the magnitude relationship between the rigidity of the support structures may be implemented using different materials of the support structures.

Further, there are various quantities and arrangement locations of first support structures 031 and second support structures 032 in the first support part 03 of the electromagnetic micromirror.

For example, as shown in FIG. 1, FIG. 2, or FIG. 4, the first support part 03 includes the first support structure 031 and two groups of second support structures 032 located on two sides of the first support structure 031. One group of second support structures 032 may include at least one second support structure 032. In FIG. 1, for example, one group of second support structures 032 includes one second support structure 032.

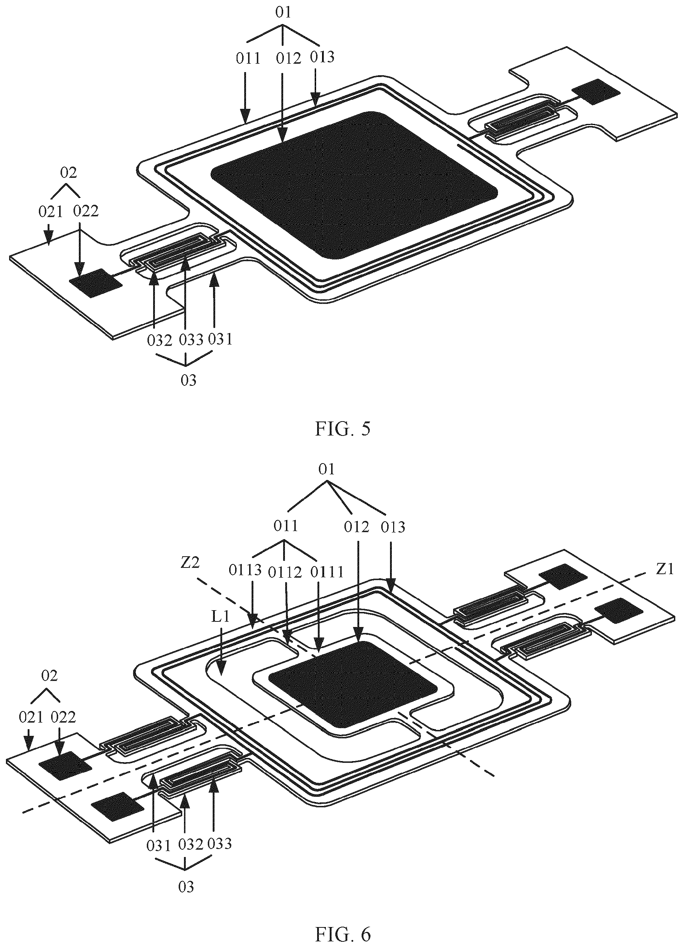

For another example, as shown in FIG. 5, on a basis of FIG. 1, alternatively, the first support part 03 may not include the first support structure 031 and two groups of second support structures 032 located on two sides of the first support structure 031, but includes the second support structure 032 and two groups of first support structures 031 located on two sides of the second support structure 032.

Regardless of whether the first support structure 031 and the second support structure 032 are arranged in the manner shown in FIG. 1 or FIG. 5, the electromagnetic micromirror has capabilities to reduce, via the second support structure 032, a risk that the first routed wire is broken under an action of stress of the support structure, and ensure reliability of the electromagnetic micromirror via the first support structure 031. In addition, compared with that in the arrangement manner shown in FIG. 5, in the arrangement manner shown in FIG. 1, the risk that the first routed wire is broken under the action of the stress of the support structure can be greatly reduced. Compared with that in the arrangement manner shown in FIG. 1, in the arrangement manner shown in FIG. 5, reliability of the electromagnetic micromirror can be greatly improved. In addition, in the arrangement manner shown in FIG. 1, energy consumption required by the movable part to move is lower.

Further, regardless of how the first support structure 031 and the second support structure 032 are arranged, there may be a correspondence between the first electrode 022 on the fastened plate 021 of the electromagnetic micromirror and the second support structure 032. For example, when the electromagnetic micromirror includes a plurality of second support structures 032, the fastened plate 021 has a plurality of first electrodes 022 that are in one-to-one correspondence with the plurality of second support structures 032, and first routed wires 033 on the second support structures 032 are connected to the first electrodes 022 corresponding to the second support structures 032.

Further, the electromagnetic micromirror may include one first support part 03, or may include a plurality of first support parts 03. This is not limited in embodiments of this application. For example, as shown in FIG. 1 to FIG. 5, the electromagnetic micromirror includes two groups of first support parts 03 located on two opposite sides of the reflector 012. One group of first support parts 03 may include one or more first support parts 03. In this embodiment of this application, for example, one group of first support parts 03 includes one first support part 03. In addition, when the electromagnetic micromirror includes a plurality of first support parts 03, the plurality of first support parts 03 may include different first support parts 03, or the plurality of first support parts 03 are all the same. This is not limited in embodiments of this application.

Regardless of a quantity of first support parts 03 included in the electromagnetic micromirror, the fastened part 02 may include one or more fastened plates 021. For example, when the electromagnetic micromirror includes the two groups of first support parts 03 located on the two opposite sides of the reflector 012, the fastened part 02 includes two fastened plates 021 that are in one-to-one correspondence with the two groups of first support parts 03. For one first support part 03 in one group of first support parts 03 that corresponds to one fastened plate 021, the first support part 03 is located between the fastened plate 021 and the reflector 012, both a first support structure 031 and a second support structure 032 in the first support part 03 are connected to the fastened plate 021, and a first routed wire 033 on the second support structure 032 is connected to a first electrode 022 on the fastened plate 021.

Further, in the embodiments shown in FIG. 1 to FIG. 5, the framework 011 is in a solid plate shape. The reflector 012 and the first electromagnetic coil 013 are located on the framework 011. Optionally, the framework 011 may alternatively be implemented in another manner.

For example, FIG. 6 is a diagram of a structure of another electromagnetic micromirror according to an embodiment of this application. As shown in FIG. 6, on the basis of FIG. 1, the framework 011 includes a first inner frame 0111, a second support part 0112, and a first outer frame 0113. The first outer frame 0113 surrounds the first inner frame 0111, and is spaced from the first inner frame 0111. The reflector 012 is located on the first inner frame 0111. The first electromagnetic coil 013 is located on the first outer frame 0113. The first support part 03 is connected to the first outer frame 0113. The second support part 0112 is located between the first outer frame 0113 and the first inner frame 0111, and connects the first outer frame 0113 to the first inner frame 0111. A first hollow area L1 exists between the first outer frame 0113 and the first inner frame 0111. The first support part 03 and the second support part 0112 are located in different orientations of the reflector 012.

In this embodiment of this application, an example in which the framework 011 includes the first inner frame 0111, the second support part 0112, and the first outer frame 0113 on a basis of the electromagnetic micromirror shown in FIG. 1 is used. It may be understood that the framework 011 may also include the first inner frame 0111, the second support part 0112, and the first outer frame 0113 on the basis of the electromagnetic micromirror shown in FIG. 3 to FIG. 5. Details are not described herein in this embodiment of this application.

When the framework 011 includes the first inner frame 0111, the second support part 0112, and the first outer frame 0113, the first electromagnetic coil 013 may be driven, by changing the drive electrical signal loaded on the first electrode 022, to drive the reflector 012 to perform different motion (for example, rotate around different rotation axes). For example, when a first drive electrical signal is loaded on the first electrode 022, the first electromagnetic coil 013 can drive the reflector 012 to rotate, and the rotation axis of the reflector 012 is parallel to the arrangement direction of the reflector 012 and the first support part 03. For example, the rotation axis may be the rotation axis Z1 in FIG. 6. When a second drive electrical signal is loaded on the first electrode 022, the first electromagnetic coil 013 can drive the reflector 012 to rotate, and the rotation axis of the reflector 012 is parallel to an arrangement direction of the reflector 012 and the second support part 0112. For example, the rotation axis may be a rotation axis Z2 in FIG. 6. The first drive electrical signal and the second drive electrical signal may be currents in opposite directions.

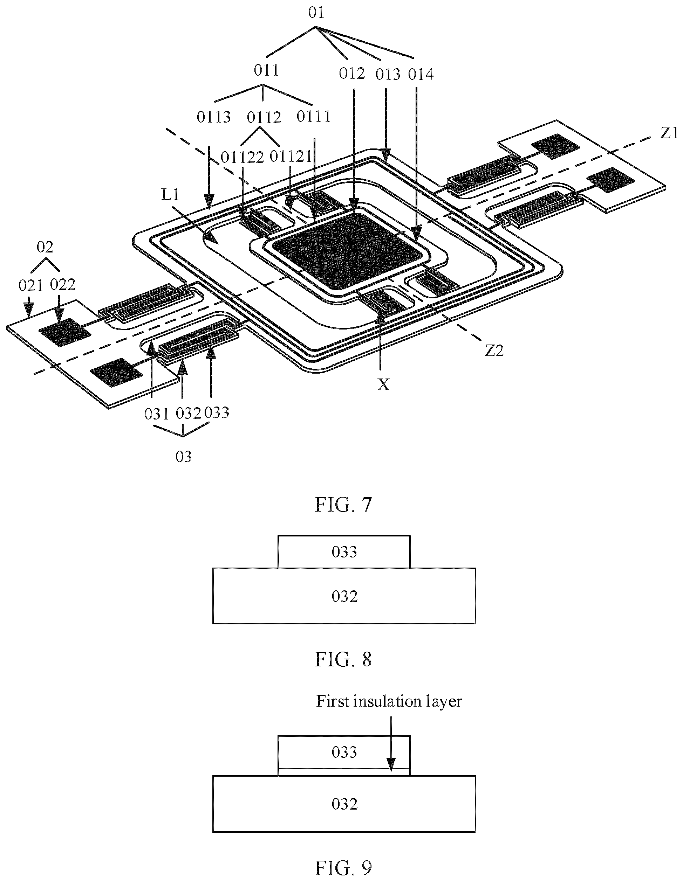

Further, when the framework 011 includes the first inner frame 0111, the second support part 0112, and the first outer frame 0113, as shown in FIG. 7, on a basis of the electromagnetic micromirror shown in FIG. 6, the movable part 01 further includes a second electromagnetic coil 014. The second electromagnetic coil 014 is located on the first inner frame 0111, and is configured to drive the reflector 012 to move. For example, the second electromagnetic coil 014 and the reflector 012 may be located on a same side of the framework 011, the second electromagnetic coil 014 surrounds the reflector 012, and the second electromagnetic coil 014 and the reflector 012 are spaced from each other. For another example, alternatively, the second electromagnetic coil 014 and the reflector 012 may not be located on a same side of the framework 011, but are located on two opposite sides of the framework 011.

The second support part 0112 includes a third support structure 01121 and a fourth support structure 01122. Both the third support structure 01121 and the fourth support structure 01122 connect the first outer frame 0113 to the first inner frame 0111. Rigidity of the third support structure 01121 is higher than rigidity of the fourth support structure 01122. In this case, the fastened part 02 further includes a second electrode (which is not shown in FIG. 7) located on the fastened plate 021. The fourth support structure 01122, the first outer frame 0113, and the second support structure 032 have a second routed wire that connects the second electrode 012 to the second electromagnetic coil 014 (FIG. 7 shows only a second routed wire X on the second support structure 032). The second routed wire is insulated from the first routed wire 033.

It should be noted that the second routed wire is configured to connect the second electrode 012 to the second electromagnetic coil 014, and the second routed wire needs to pass through the fourth support structure 01122, the first outer frame 0113, and the second support structure 032. The first outer frame 0113 has the first electromagnetic coil 013, the second support structure 032 has the first routed wire 033, and the first routed wire 033 is connected to the first electromagnetic coil 013.

The first electromagnetic coil 013 and the second electromagnetic coil 014 may be located on a same side of the framework 011, or may be located on different sides of the framework 011. This is not limited in embodiments of this application. Correspondingly, the first routed wire 033 connected to the first electromagnetic coil 013 and the second routed wire connected to the second electromagnetic coil 014 may be located on a same side or different sides of the framework 011.

When the first electromagnetic coil 013 and the second electromagnetic coil 014 are located on the same side of the framework 011, the first routed wire 033 and the second routed wire are located on the same side of the framework 011. In this case, to insulate the second routed wire from the first routed wire 033, the first routed wire 033 and the second routed wire may be separately placed at different locations on the second support structure 032, or the first routed wire 033 and the second routed wire are stacked on the second support structure 032, and the first routed wire 033 is spaced from the second routed wire using an insulation layer. To insulate the second routed wire from the first electromagnetic coil 013, the second routed wire and the first electromagnetic coil 013 may be separately placed at different locations on the first outer frame 0113, or the second routed wire and the first electromagnetic coil 013 are stacked on the first outer frame 0113, and the second routed wire is spaced from the first electromagnetic coil 013 using an insulation layer.

In addition, if the second routed wire needs to overlap the first electromagnetic coil 013, or the second routed wire needs to overlap the first routed wire 033, a bridging manner may be used, so that the second routed wire is insulated from the first electromagnetic coil 013 and the first routed wire 033. For example, when the second routed wire needs to overlap the first electromagnetic coil 013, an insulation bridge may be lapped on the first electromagnetic coil 013, and the second routed wire crosses the first electromagnetic coil 013 from the insulation bridge, to prevent the second routed wire from being connected to the first electromagnetic coil 013.

When the movable part 01 includes the first electromagnetic coil 013 and the second electromagnetic coil 014, drive electrical signals may be loaded to different electromagnetic coils through different electrodes, so that different electromagnetic coils drive the reflector 012 to perform different motion (for example, rotate around different rotation axes). For example, when the first drive electrical signal is loaded on the first electrode 022, the first electromagnetic coil 013 can drive the reflector 012 to rotate, and the rotation axis of the reflector 012 is parallel to the arrangement direction of the reflector 012 and the first support part 03. For example, the rotation axis may be the rotation axis Z1 in FIG. 7. When the second drive electrical signal is loaded on the second electrode, the second electromagnetic coil 014 can drive the reflector 012 to rotate, and the rotation axis of the reflector 012 is parallel to the arrangement direction of the reflector 012 and the second support part 0112. For example, the rotation axis may be the rotation axis Z2 in FIG. 7. The first drive electrical signal and the second drive electrical signal may be the currents in the opposite directions.

In addition, similar to that the first support part 03 includes the first support structure 031 with higher rigidity and the second support structure 032 with the lower rigidity, the second support part 0112 also includes the third support structure 01121 with higher rigidity and the fourth support structure 01122 with lower rigidity. The second routed wire is located on the fourth support structure 01122. In this way, because stress of the fourth support structure 01122 is lower, when the reflector 012 moves, a risk that the second routed wire is broken under an action of the stress of the support structure can be reduced. In addition, because the rigidity of the third support structure is higher, under an action of the third support structure, a stable connection between the first outer frame and the first inner frame can be ensured, to ensure reliability of the electromagnetic micromirror.

For a shape, a material, an arrangement location, and the like of the third support structure 01121, refer to those of the first support structure 031. For a shape, a material, an arrangement location, and the like of the fourth support structure 01122, refer to those of the second support structure 032.

For example, both the third support structure 01121 and the fourth support structure 01122 are also in the line shape, an equivalent length of the third support structure 01121 is less than an equivalent length of the fourth support structure 01122, and an equivalent width of the third support structure 01121 is greater than an equivalent width of the fourth support structure 01122. For example, twice the equivalent length of the third support structure 01121 is less than the equivalent length of the fourth support structure 01122. The third support structure 01121 may be in the straight-line shape, and/or the fourth support structure 01122 may be in the serpentine shape. Materials of the third support structure 01121, the fourth support structure 01122, the first inner frame 0111, and the first outer frame 0113 may be the same. The second support part 0112 may include the third support structure 01121 and two groups of fourth support structures 01122 located on two sides of the third support structure 01121. Alternatively, the second support part 0112 may include the fourth support structure 01122 and two groups of third support structures 01121 located on two sides of the fourth support structure 01122. The fastened plate 021 may have a plurality of second electrodes. The second support part 0112 may include a plurality of fourth support structures 01122 that are in one-to-one correspondence with the plurality of second electrodes. Second routed wires on the fourth support structures 01122 are connected to the second electrodes corresponding to the fourth support structures 01122. The electromagnetic micromirror may include two groups of second support parts 0112 located on two opposite sides of the reflector 012. When the electromagnetic micromirror includes a plurality of second support parts 0112, the plurality of second support parts 0112 may include different second support parts 0112, or the plurality of second support parts 0112 may be the same.

Further, in this embodiment of this application, the electromagnetic micromirror may include the first routed wire 033, or the first routed wire 033 and the second routed wire. For any routed wire (for example, the first routed wire 033 or the second routed wire) in the electromagnetic micromirror, the routed wire may meet any one of the following four conditions.

Condition 1: The routed wire may be in contact with a component on which the routed wire is located. A component on which the first routed wire 033 is located may be the second support structure 032. A component on which the second routed wire is located may be the fourth support structure 01122, the first outer frame 0113, and/or the second support structure 032. For example, FIG. 8 is a diagram of a cross section of any location that is on the second support structure 032 in FIG. 1 and at which the first routed wire 033 is disposed. As shown in FIG. 8, the first routed wire 033 is in contact with the second support structure 032.

Condition 2: A first insulation layer exists between the routed wire and a component on which the routed wire is located. For example, as shown in FIG. 9, on a basis of FIG. 8, a first insulation layer exists between the first routed wire 033 and the second support structure 032.

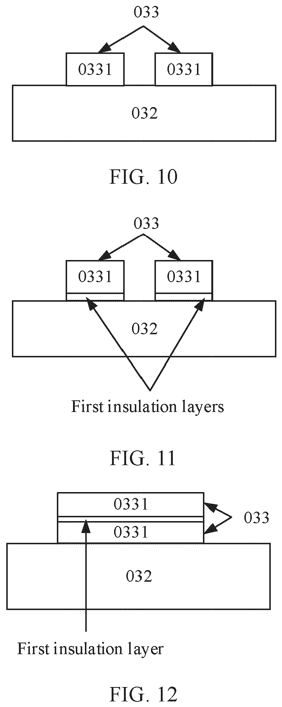

Condition 3: The routed wire includes a plurality of sub-wires connected in parallel, and orthographic projections of the plurality of sub-wires on a component on which the routed wire is located are spaced from each other. For example, as shown in FIG. 10, on a basis of FIG. 8, the first routed wire 033 includes two sub-wires 0331, the two sub-wires 0331 are located at a same layer, and are both in contact with the second support structure 032, and the two sub-wires 0331 are insulated from each other. Alternatively, as shown in FIG. 11, on a basis of FIG. 9, the first routed wire 033 includes two sub-wires 0331, the two sub-wires 0331 are located at a same layer, a first insulation layer exists between each of the two sub-wires and the second support structure 032, and the two sub-wires 0331 are insulated from each other.

Condition 4: The routed wire includes a plurality of sub-wires connected in parallel, orthographic projections of the plurality of sub-wires on a component on which the routed wire is located at least partially overlap, and the routed wire further includes a second insulation layer located between the plurality of sub-wires. For example, as shown in FIG. 12, on a basis of FIG. 8, the first routed wire 033 includes two sub-wires 0331, the two sub-wires 0331 are located and stacked on the second support structure 032, and a second insulation layer exists between the two sub-wires 0331.

Certainly, the routed wire may alternatively be implemented in another manner. Examples are not provided one by one herein in this embodiment of this application.

Optionally, materials of the fastened plate 021, the first support structure 031, the second support structure 032, and the framework 011 are the same. In this way, a same material layer may be processed, to produce and obtain the fastened plate 021, the first support structure 031, the second support structure 032, and the framework 011 at the same time.

Optionally, materials of the reflector 012, the routed wire (for example, the first routed wire 033, or the first routed wire 033 and the second routed wire) in the electromagnetic micromirror, and an electrode (for example, the first electrode 022, or the first electrode 022 and the second electrode) in the electromagnetic micromirror are the same. In this way, a same material layer may be processed, to produce and obtain the reflector 012, and the routed wire and the electrode in the electromagnetic micromirror at the same time. For example, the first routed wire and the second routed wire in this embodiment of this application may be a conductive material like metal.

Further, a portion in the electromagnetic micromirror provided in this embodiment of this application other than an electromagnetic coil may be an axisymmetric structure (or an approximately axisymmetric structure) or a non-axisymmetric structure. For example, an orthographic projection of the portion in the electromagnetic micromirror other than the electromagnetic coil on a reference plane parallel to the reflector is an axisymmetric pattern (or an approximately axisymmetric pattern). The axisymmetric pattern has at least one of a first symmetry axis and a second symmetry axis. The first symmetry axis and the second symmetry axis are perpendicular and both pass through a center of an orthographic projection of the reflector on the reference plane. The electromagnetic micromirror shown in FIG. 6 is used as an example. The first symmetry axis may be an orthographic projection of the rotation axis Z1 on the reference plane, and the second symmetry axis may be an orthographic projection of the rotation axis Z2 on the reference plane.

In addition, the electromagnetic micromirror provided in embodiments of this application may be produced and obtained using a micro-electro-mechanical system (micro-electro-mechanical system, MEMS) technology. Therefore, the electromagnetic micromirror may also be referred to as an MEMS electromagnetic micromirror.

Based on the electromagnetic micromirror provided in embodiments of this application, an embodiment of this application provides a micromirror system. The micromirror system may be a micromirror system including an electromagnetic micromirror, for example, an optical system (for example, a lidar (for example, a lidar used in a driverless vehicle), a projector, or a microprojector) or a micromirror.

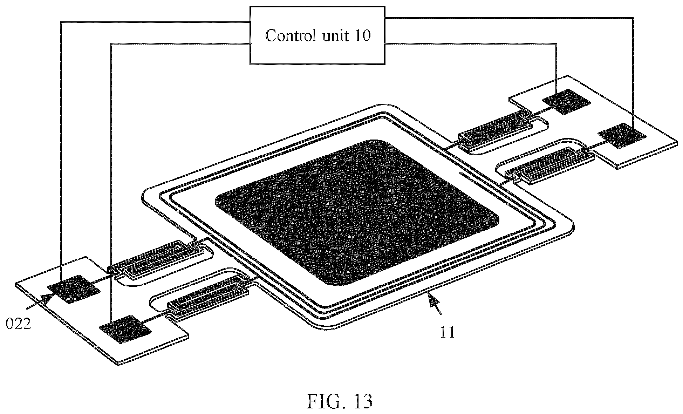

For example, as shown in FIG. 13, the micromirror system includes a drive unit 10 and any electromagnetic micromirror 11 provided in embodiments of this application. In FIG. 13, the electromagnetic micromirror shown in FIG. 1 is used as an example. Certainly, the electromagnetic micromirror in FIG. 13 may alternatively be another electromagnetic micromirror provided in embodiments of this application other than the electromagnetic micromirror shown in FIG. 1.

Refer to FIG. 13. The drive unit 10 is connected to an electrode (for example, the first electrode 022, or the first electrode 022 and the second electrode) in the electromagnetic micromirror 11. For example, the drive unit 10 is connected to the electrode through a conducting wire, and the conducting wire may be a routed wire or bonding wire. This is not limited in embodiments of this application.

The drive unit 10 is configured to provide a drive electrical signal for the electrode in the electromagnetic micromirror 11, to drive the movable part in the electromagnetic micromirror to move. For the drive electrical signal, refer to the related descriptions in the foregoing electromagnetic micromirror embodiments. Details are not described in this embodiment of this application. The drive unit may adjust the drive electrical signal provided for the electrode of the electromagnetic micromirror 11, to adjust parameters such as a rotation angle and a motion frequency of the reflector. The drive unit may further read information such as the rotation angle.

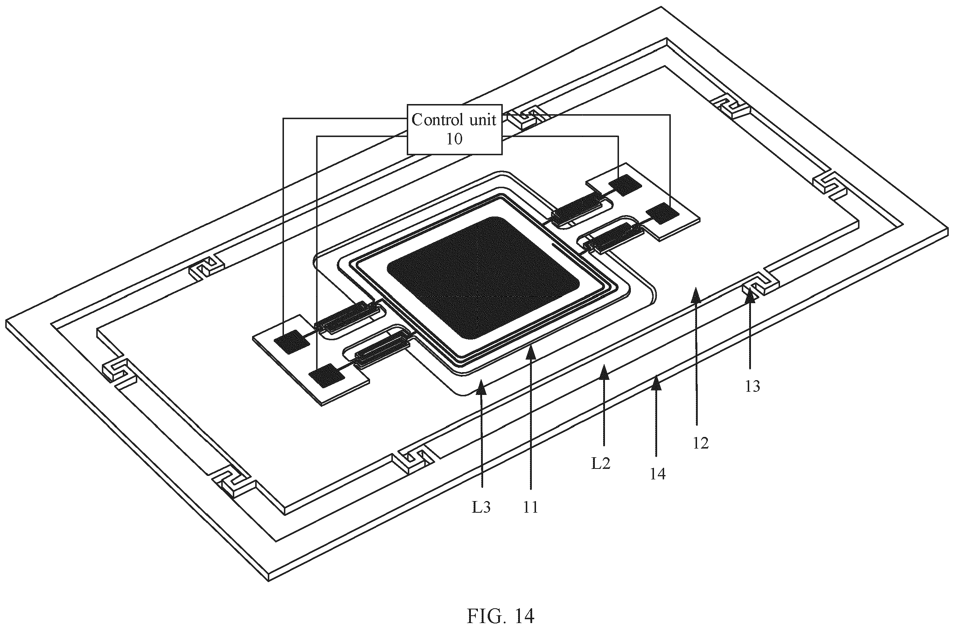

Further, as shown in FIG. 14, on a basis of the micromirror system shown in FIG. 13, the micromirror system provided in this embodiment of this application further includes a second inner frame 12, a connection part 13, and a second outer frame 14 that correspond to the electromagnetic micromirror 11. A whole including the second inner frame 12, the connection part 13, and the second outer frame 14 may be referred to as a backup plate. The second inner frame 12 may be an insulation material, a conductive material, or a magnet. This is not limited in embodiments of this application. The second outer frame 14 surrounds the second inner frame 12. The second outer frame 14 and the second inner frame 12 are spaced from each other. The connection part 13 is between the second outer frame 14 and the second inner frame 12, and connects the second outer frame 14 to the second inner frame 12. A second hollow area L2 exists between the second outer frame 14 and the second inner frame 12. The fastened plate 021 is fastened to the second inner frame 12. As shown in FIG. 14, the second inner frame 12 has a third hollow area L3, and an orthographic projection of the movable part 01 on a reference plane parallel to the reflector is located in an orthographic projection of the third hollow area L3 on the reference plane. In this case, the movable part 01 may move in the third hollow area L3.

It should be noted that, in FIG. 14, an example in which the micromirror system further includes the second inner frame, the connection part, and the second outer frame on a basis of the micromirror system shown in FIG. 13 is used. On a basis of another micromirror system provided in an embodiment of this application, the micromirror system may further include the second inner frame, the connection part, and a second outer frame. Details are not described herein in this embodiment of this application.

When the micromirror system includes the second inner frame 12, the connection part 13, and the second outer frame 14, the connection part 13 and the second hollow area L2 exist between the second inner frame 12 and the second outer frame 14. When the electromagnetic micromirror is packaged, the fastened part 02 may be fastened to the second inner frame 12 in a manner like an adhesive, bonding, or soldering. In this case, under an action of the connection part 13 and the second hollow area L2, stress applied to the fastened part 02 is low. Therefore, packaging stress of the electromagnetic micromirror is reduced, impact of the packaging stress on the electromagnetic micromirror is reduced, and performance of the electromagnetic micromirror is improved.

Optionally, materials of the second inner frame 12, the connection part 13, and the second outer frame 14 are the same. In this way, a same material layer may be processed, to produce and obtain the second inner frame 12, the connection part 13, and the second outer frame 14 at the same time.

Optionally, the connection part 13 may be in various shapes. This is not limited in embodiments of this application. For example, the connection part 13 may also be in a line shape (for example, a straight-line shape, a curvilinear shape, a broken-line shape, or a serpentine shape), and an extension direction of the connection part 13 may be parallel to or perpendicular to an arrangement direction of the second inner frame 12 and the second outer frame 14. In FIG. 14, for example, the connection part 13 is in the serpentine shape and the extension direction of the connection part 13 is perpendicular to the arrangement direction. In addition, to further reduce the packaging stress applied to the electromagnetic micromirror, when the connection part 13 may also be in the linear shape, an equivalent length of the connection part 13 may be greater than a spacing between the second outer frame 14 and the second inner frame 12. Certainly, the equivalent length of the connection part 13 may alternatively be equal to the spacing. This is not limited in embodiments of this application.

Further, as shown in FIG. 14, an orthographic projection of the first support part 03 on the reference plane parallel to the reflector and an orthographic projection of the second inner frame 12 on the reference plane may at least partially overlap. In FIG. 14, an example in which the orthographic projection of the first support structure 031 on the reference plane and the orthographic projection of the second inner frame 12 on the reference plane at least partially overlap is used. Certainly, alternatively, orthographic projections of other structures (for example, the first support structure 031 and the second support structure 032) of the first support part 03 on the reference plane and the orthographic projection of the second inner frame 12 on the reference plane may at least partially overlap, or an orthographic projection of the first support part 03 on the reference plane does not overlap an orthographic projection of the second inner frame 12 on the reference plane. This is not limited in embodiments of this application.

It can be learned from the foregoing embodiment that, before delivery of the electromagnetic micromirror, the electromagnetic micromirror needs to be shaken, to perform a reliability test on the electromagnetic micromirror. However, in a process of shaking the electromagnetic micromirror, a support beam is prone to breakage, and therefore the electromagnetic micromirror cannot be used, resulting in low reliability of the electromagnetic micromirror. In the micromirror system provided in this embodiment of this application, the orthographic projection of the first support part 03 on the reference plane parallel to the reflector and the orthographic projection of the second inner frame 12 on the reference plane at least partially overlap. Therefore, at least a partial area in the first support part 03 can be supported by the second inner frame 12. When the reliability test is performed on the electromagnetic micromirror, under a support action of the second inner frame 12, force applied to the first support part 03 can be buffered on the second inner frame 12. This can reduce a risk that the first support part 03 is broken, thereby improving reliability of the electromagnetic micromirror.

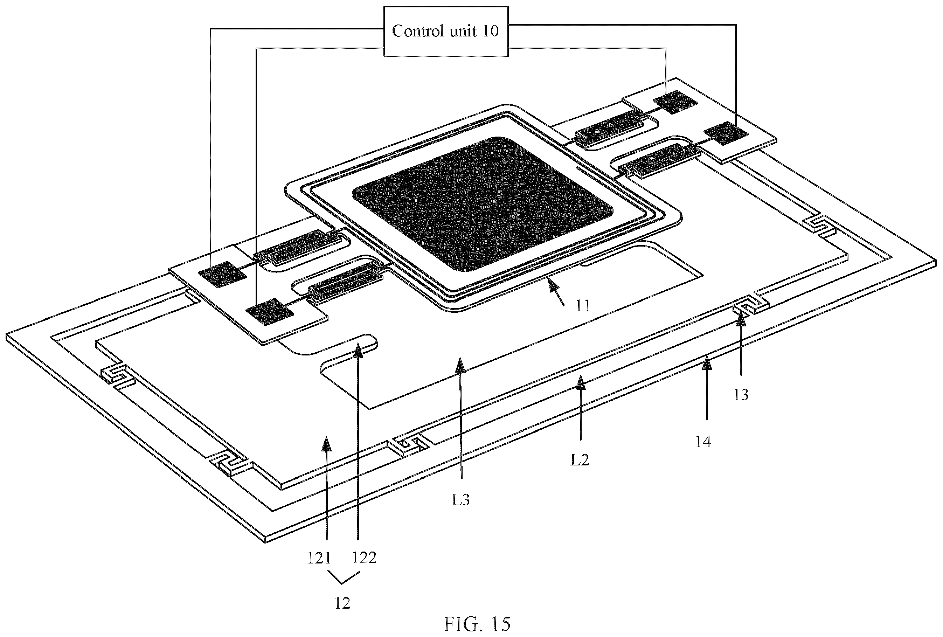

There may be a plurality of implementations in which the orthographic projection of the first support part 03 on the reference plane parallel to the reflector and the orthographic projection of the second inner frame 12 on the reference plane at least partially overlap. For example, in an optional implementation, as shown in FIG. 15, the second inner frame 12 includes an inner frame part 121 and a stop part 122 that are connected to each other. The inner frame part 121 may surround the stop part 122. The fastened plate 021 is fastened to the inner frame part 121. At least a partial orthographic projection of the first support part 03 on the reference plane and an orthographic projection of the stop part 122 on the reference plane at least partially overlap. In this case, the stop part 122 is configured to support the first support part 03 when the reliability test is performed on the electromagnetic micromirror.

For example, an orthographic projection, on the reference plane, of a portion that is of the stop part 122 and that protrudes from the inner frame part 121 may be in the line shape, and a length of the orthographic projection may be less than 4000 micrometers, and a width of the orthographic projection may be less than 2000 micrometers.

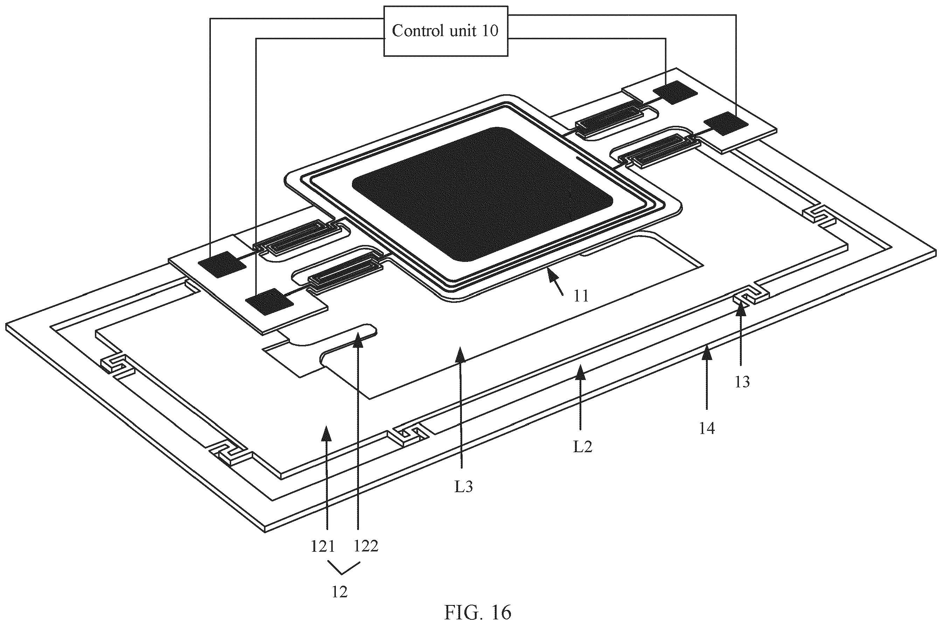

Further, as shown in FIG. 16, on a basis of FIG. 15, in a thickness direction of the second inner frame 12, a thickness of the stop part 122 is less than a thickness of the inner frame part 121. In this way, elasticity of the stop part 122 can be improved, mechanical rigidity of the stop part 122 can be reduced, and an effect of buffering, on the stop part 122, the force applied to the first support part 03 can be improved. Certainly, a thickness of the stop part 122 may alternatively be greater than or equal to a thickness of the inner frame part 121. This is not limited in embodiments of this application.

In the foregoing embodiment, an example in which the micromirror system includes one electromagnetic micromirror is used. Optionally, the micromirror system may alternatively include a plurality of electromagnetic micromirrors. The plurality of electromagnetic micromirrors may be the same, or the plurality of electromagnetic micromirrors may include different electromagnetic micromirrors.

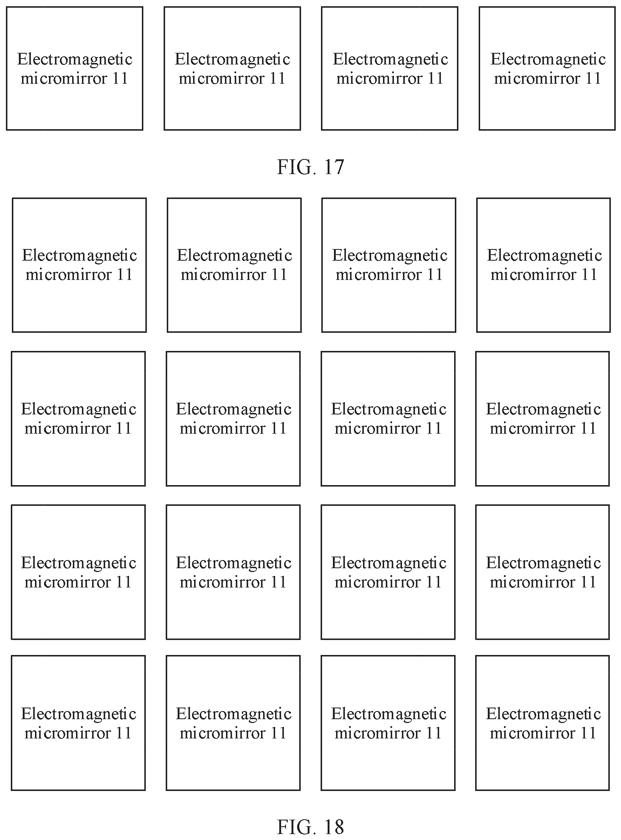

For example, when the micromirror system includes the plurality of electromagnetic micromirrors, the plurality of electromagnetic micromirrors may be arranged in an array or may not be arranged in an array. For example, when the electromagnetic micromirror includes two groups of first support parts located on two opposite sides of the reflector, a row direction or a column direction of the plurality of electromagnetic micromirrors is an arrangement direction of the two groups of first support parts. As shown in FIG. 17, the micromirror system includes four electromagnetic micromirrors 11, and the four electromagnetic micromirrors 11 are arranged in one column in a direction perpendicular to the arrangement direction of the two groups of first support parts 03. As shown in FIG. 18, the micromirror system includes 16 electromagnetic micromirrors 11, the 16 electromagnetic micromirrors 11 are arranged in four rows and four columns, and a column direction of the 16 electromagnetic micromirrors 11 is the arrangement direction of the two groups of first support parts 03.

In addition, when the micromirror system includes the plurality of electromagnetic micromirrors, second inner frames, connection parts, and second outer frames that correspond to different electromagnetic micromirrors may be the same, or may be independent of each other.

For example, if the plurality of electromagnetic micromirrors correspond to a same second inner frame, a same connection part, and a same second outer frame, the second outer frame and the second inner frame are connected to each other via the connection part, and all fastened plates in the plurality of electromagnetic micromirrors are fastened to the second inner frame. The second inner frame may include a plurality of annular areas that are in one-to-one correspondence with the plurality of electromagnetic micromirrors. For one electromagnetic micromirror and an annular area corresponding to the electromagnetic micromirror, the annular area includes an inner frame part and a stop part, a fastened plate in the electromagnetic micromirror is fastened to the inner frame part, and at least a partial orthographic projection of a first support part in the electromagnetic micromirror on the second inner frame is located on the stop part.

For another example, if the plurality of electromagnetic micromirrors correspond to different second inner frames, different connection parts, and different second outer frames, the micromirror system may include a drive unit and a plurality of micromirror units. Each micromirror unit includes an electromagnetic micromirror, and a second inner frame, a connection part, and a second outer frame that correspond to the electromagnetic micromirror. The second inner frame is connected to the second outer frame via the connection part. A fastened plate of the electromagnetic micromirror is fastened to the second inner frame. In addition, the second inner frame includes an inner frame part and a stop part, a fastened plate in the electromagnetic micromirror is fastened to the inner frame part, and at least a partial orthographic projection of a first support part in the electromagnetic micromirror on the second inner frame is located on the stop part.

In addition, a whole including the electromagnetic micromirror, the second inner frame, the connection part, and the second outer frame in the micromirror system provided in this embodiment of this application may also be an axisymmetric structure (or an approximately axisymmetric structure) or a non-axisymmetric structure. For example, an orthographic projection of the whole on the reference plane parallel to the reflector is an axisymmetric pattern (or an approximately axisymmetric pattern), and the axisymmetric pattern also has at least one of the first symmetry axis and the second symmetry axis.

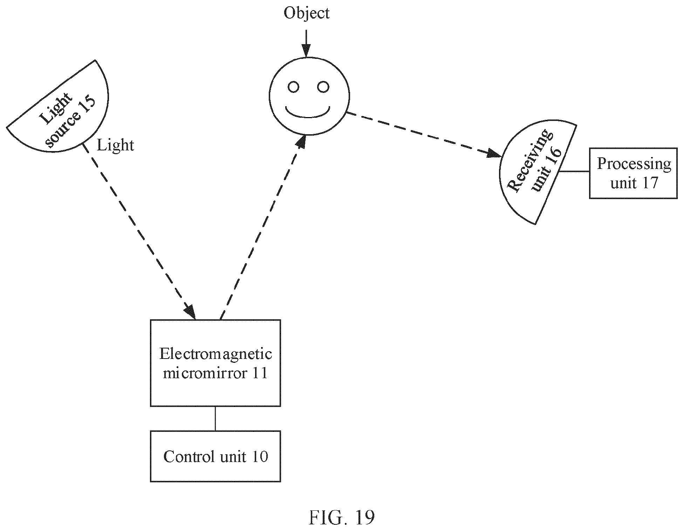

The micromirror system provided in this embodiment of this application may further include a light source, and/or a receiving unit and a processing unit. For example, as shown in FIG. 19, the micromirror system includes the drive unit 10, the electromagnetic micromirror 11, a light source 15, a receiving unit 16, and a processing unit 17. FIG. 19 does not show the second inner frame 12, the connection part 13, and the second outer frame 14 in the micromirror system. In this embodiment of this application, an example in which the micromirror system includes the light source, the receiving unit, and the processing unit is used. Optionally, alternatively, the micromirror system may not include a light source, a receiving unit, and a processing unit.

The light source 15 is configured to emit light (for example, laser) to the reflector in the electromagnetic micromirror 11. In this case, the reflector is configured to reflect received light. For example, the reflector is configured to reflect the received light in a moving process. The receiving unit 16 is configured to: receive light that is reflected by the reflector after being reflected by an object, and provide an electrical signal of the object for the processing unit 17 based on the received light. The processing unit 17 is configured to output scanning information of the object (for example, a two-dimensional image or a three-dimensional image of the object) based on the received electrical signal of the object.

In this application, "at least one" means one or more, and "a plurality of" means two or more. "At least one of the following items" or a similar expression thereof means any combination of these items, including any combination of singular items or plural items. For example, at least one of a, b, or c may indicate a, b, c, a+b, a+c, b+c, or a+b+c, where a, b, and c may be singular or plural.

It should be noted that, in the accompanying drawings, for illustration clarity, sizes of some or all layers or sizes of some or all areas may be enlarged. In addition, it may be understood that, when an element or a layer is referred to as being "on" another element or layer, the element or the layer may be directly on the another element, or an intermediate layer may exist.

In this disclosure, the terms "first" and "second" are merely intended for description, and shall not be understood as an indication or implication of relative importance. The term "a plurality of" means two or more, unless otherwise expressly limited.

The term "and/or" in this application describes only an association relationship between associated objects and indicates that three relationships may exist. For example, A and/or B may indicate the following three cases: Only A exists, both A and B exist, and only B exists. In addition, the character "/" in this specification generally indicates an "or" relationship between associated objects.

The foregoing descriptions are merely optional embodiments of this application, but are not intended to limit this application.

## Claims

1. An electromagnetic micromirror (11), comprising a movable part (01), a fastened part (02), and a first support part (03), wherein
the movable part (01) comprises a framework (011), and a reflector (012) and a first electromagnetic coil (013) that are located on the framework (01), wherein the first electromagnetic coil is configured to drive the reflector (012) to move, and the reflector (012) has a reflective surface that backs onto the framework (011);
the fastened part (02) comprises a fastened plate (021) and a first electrode (022) located on the fastened plate (021); and
the first support part (03) comprises a first support structure (031) and a second support structure (032) that are spaced from each other, wherein both the first support structure (031) and the second support structure (032) connect the framework (011) to the fastened plate (021), rigidity of the first support structure (031) is higher than rigidity of the second support structure (032), and the second support structure (032) has a first routed wire (033) that connects the first electrode (022) to the first electromagnetic coil (013),
wherein the first support part (03) meets any one of the following conditions:
the first support part (03) comprises the first support structure and two groups of second support structures located on two sides of the first support structure; and
the first support part (03) comprises the second support structure and two groups of first support structures located on two sides of the second support structure.

2. The electromagnetic micromirror (11) according to claim 1, wherein both the first support structure (031) and the second support structure (032) are in a line shape, an equivalent length of the first support structure (031) is less than an equivalent length of the second support structure (032), and an equivalent width of the first support structure (031) is greater than an equivalent width of the second support structure (032).

3. The electromagnetic micromirror (11) according to claim 2, wherein twice the equivalent length of the first support structure (031) is less than the equivalent length of the second support structure (032).

4. The electromagnetic micromirror (11) according to any one of claims 1 to 3, wherein the first support part (03) meets at least one of the following conditions:
the first support structure (031) is in a straight-line shape; and
the second support structure (032) is in a serpentine shape.

5. The electromagnetic micromirror (11) according to any one of claims 1 to 4, wherein materials of the first support structure (031), the second support structure (032), and the framework (011) are the same.

6. The electromagnetic micromirror (11) according to any one of claims 1 to 5, wherein the fastened plate (021) has a plurality of first electrodes, the first support part (03) comprises a plurality of second support structures that are in one-to-one correspondence with the plurality of first electrodes, and first routed wires on the second support structures are connected to the first electrodes corresponding to the second support structures.

7. The electromagnetic micromirror (11) according to any one of claims 1 to 6, wherein the electromagnetic micromirror (11) comprises two groups of first support parts located on two opposite sides of the reflector (012).

8. The electromagnetic micromirror (11) according to claim 7, wherein the fastened part (02) comprises two fastened plates that are in one-to-one correspondence with the two groups of first support parts; and
for one first support part in one group of first support parts that corresponds to one fastened plate, the first support part is located between the fastened plate and the reflector (012), both a first support structure and a second support structure in the first support part are connected to the fastened plate, and a first routed wire on the second support structure is connected to a first electrode on the fastened plate.

9. The electromagnetic micromirror (11) according to any one of claims 1 to 8, wherein the framework (011) comprises a first inner frame (0111), a second support part (0112), and a first outer frame (0113);
the first outer frame (0113) surrounds the first inner frame (0111), and is spaced from the first inner frame (0111), the reflector (012) is located on the first inner frame (0111), the first electromagnetic coil (013) is located on the first outer frame (0113), and the first support part (03) is connected to the first outer frame (0113); and
the second support part (0112) is located between the first outer frame (0113) and the first inner frame (0111), and connects the first outer frame (0113) to the first inner frame (0111), a first hollow area exists between the first outer frame (0113) and the first inner frame (0111), and the first support part (03) and the second support part (0112) are located in different orientations of the reflector (012).

10. The electromagnetic micromirror (11) according to claim 9, wherein the movable part (01) further comprises a second electromagnetic coil (014), the second electromagnetic coil (014) is located on the first inner frame (0111), and the second electromagnetic coil (014) is configured to drive the reflector (012) to move;
the second support part (0112) comprises a third support structure (01121) and a fourth support structure (01122), both the third support structure (01121) and the fourth support structure (01122) connect the first outer frame (0113) to the first inner frame (0111), and rigidity of the third support structure (01121) is higher than rigidity of the fourth support structure (01122); and
the fastened part (02) further comprises a second electrode located on the fastened plate (021), the fourth support structure (01122), the first outer frame (0113), and the second support structure (032) have a second routed wire that connects the second electrode to the second electromagnetic coil (014), and the second routed wire is insulated from the first routed wire (033).

11. The electromagnetic micromirror (11) according to claim 10, wherein the second support part (0112) meets any one of the following conditions:
the second support part (0112) comprises the third support structure and two groups of fourth support structures located on two sides of the third support structure; and
the second support part (0112) comprises the fourth support structure and two groups of third support structures located on two sides of the fourth support structure.

12. The electromagnetic micromirror (11) according to any one of claims 9 to 11, wherein the electromagnetic micromirror (11) comprises two groups of second support parts located on two opposite sides of the reflector (012).

13. The electromagnetic micromirror (11) according to any one of claims 1 to 12, wherein a routed wire in the electromagnetic micromirror (11) meets at least one of the following conditions:
a first insulation layer exists between the routed wire and a component on which the routed wire is located; and
the routed wire comprises a plurality of sub-wires connected in parallel, wherein orthographic projections of the plurality of sub-wires on the component on which the routed wire is located are spaced from each other; or orthographic projections of the plurality of sub-wires on the component on which the routed wire is located at least partially overlap, and the routed wire further comprises a second insulation layer located between the plurality of sub-wires.

14. The electromagnetic micromirror (11) according to any one of claims 1 to 12, wherein the electromagnetic micromirror (11) meets at least one of the following conditions:
materials of the fastened plate (021), the first support structure (031), the second support structure (032), and the framework (011) are the same; and
materials of the reflector (012), a routed wire in the electromagnetic micromirror (11), and an electrode are the same.

## Patentansprüche

1. Elektromagnetischer Mikrospiegel (11), der ein bewegliches Teil (01), ein befestigtes Teil (02) und ein erstes Stützteil (03) umfasst, wobei
das bewegliche Teil (01) ein Gerüst (011) und einen Reflektor (012) und eine erste elektromagnetische Spule (013), die sich auf dem Gerüst (01) befinden, umfasst, wobei die erste elektromagnetische Spule dazu ausgelegt ist, den Reflektor (012) zur Bewegung anzutreiben, und der Reflektor (012) eine reflektierende Oberfläche aufweist, deren Rückseite an das Gerüst (011) angrenzt;
das befestigte Teil (02) eine befestigte Platte (021) und eine erste Elektrode (022), die sich auf der befestigten Platte (021) befindet, umfasst; und
das erste Stützteil (03) eine erste Stützstruktur (031) und eine zweite Stützstruktur (032) umfasst, die voneinander beabstandet sind, wobei sowohl die erste Stützstruktur (031) als auch die zweite Stützstruktur (032) das Gerüst (011) mit der befestigten Platte (021) verbinden, die Steifigkeit der ersten Stützstruktur (031) höher als die Steifigkeit der zweiten Stützstruktur (032) ist und die zweite Stützstruktur (032) einen ersten Leitungsdraht (033) aufweist, der die erste Elektrode (022) mit der ersten elektromagnetischen Spule (013) verbindet,
wobei das erste Stützteil (03) beliebige der folgenden Bedingungen erfüllt:
das erste Stützteil (03) umfasst die erste Stützstruktur und zwei Gruppen von zweiten Stützstrukturen, die sich auf zwei Seiten der ersten Stützstruktur befinden; und
das erste Stützteil (03) umfasst die zweite Stützstruktur und zwei Gruppen von ersten Stützstrukturen, die sich auf zwei Seiten der zweiten Stützstruktur befinden.

2. Elektromagnetischer Mikrospiegel (11) nach Anspruch 1, wobei sowohl die erste Stützstruktur (031) als auch die zweite Stützstruktur (032) linienförmig sind, eine äquivalente Länge der ersten Stützstruktur (031) kleiner als eine äquivalente Länge der zweiten Stützstruktur (032) ist und eine äquivalente Breite der ersten Stützstruktur (031) größer als eine äquivalente Breite der zweiten Stützstruktur (032) ist.

3. Elektromagnetischer Mikrospiegel (11) nach Anspruch 2, wobei die doppelte äquivalente Länge der ersten Stützstruktur (031) kleiner als die äquivalente Länge der zweiten Stützstruktur (032) ist.

4. Elektromagnetischer Mikrospiegel (11) nach einem der Ansprüche 1 bis 3, wobei das erste Stützteil (03) mindestens eine der folgenden Bedingungen erfüllt:
die erste Stützstruktur (031) ist geradlinig; und
die zweite Stützstruktur (032) ist schlangenförmig.

5. Elektromagnetischer Mikrospiegel (11) nach einem der Ansprüche 1 bis 4, wobei Materialien der ersten Stützstruktur (031), der zweiten Stützstruktur (032) und des Gerüsts (011) gleich sind.

6. Elektromagnetischer Mikrospiegel (11) nach einem der Ansprüche 1 bis 5, wobei die befestigte Platte (021) mehrere erste Elektroden aufweist, das erste Stützteil (03) mehrere zweite Stützstrukturen umfasst, die den mehreren ersten Elektroden eineindeutig entsprechen, und erste Leitungsdrähte auf den zweiten Stützstrukturen mit den ersten Elektroden verbunden sind, die den zweiten Stützstrukturen entsprechen.

7. Elektromagnetischer Mikrospiegel (11) nach einem der Ansprüche 1 bis 6, wobei der elektromagnetische Mikrospiegel (11) zwei Gruppen von ersten Stützteilen umfasst, die sich auf zwei gegenüberliegenden Seiten des Reflektors (012) befinden.

8. Elektromagnetischer Mikrospiegel (11) nach Anspruch 7, wobei das befestigte Teil (02) zwei befestigte Platten umfasst, die den zwei Gruppen von ersten Stützteilen eineindeutig entsprechen; und
für ein erstes Stützteil in einer Gruppe von ersten Stützteilen, die einer befestigten Platte entspricht, sich das erste Stützteil zwischen der befestigten Platte und dem Reflektor (012) befindet, sowohl eine erste Stützstruktur als auch eine zweite Stützstruktur in dem ersten Stützteil mit der befestigten Platte verbunden sind und ein erster Leitungsdraht auf der zweiten Stützstruktur mit einer ersten Elektrode auf der befestigten Platte verbunden ist.

9. Elektromagnetischer Mikrospiegel (11) nach einem der Ansprüche 1 bis 8, wobei das Gerüst (011) einen ersten inneren Rahmen (0111), ein zweites Stützteil (0112) und einen ersten äußeren Rahmen (0113) umfasst;
der erste äußere Rahmen (0113) den ersten inneren Rahmen (0111) umgibt und von dem ersten inneren Rahmen (0111) beabstandet ist, sich der Reflektor (012) auf dem ersten inneren Rahmen (0111) befindet, sich die erste elektromagnetische Spule (013) auf dem ersten äußeren Rahmen (0113) befindet und das erste Stützteil (03) mit dem ersten äußeren Rahmen (0113) verbunden ist; und
sich das zweite Stützteil (0112) zwischen dem ersten äußeren Rahmen (0113) und dem ersten inneren Rahmen (0111) befindet und den ersten äußeren Rahmen (0113) mit dem ersten inneren Rahmen (0111) verbindet, ein erster hohler Bereich zwischen dem ersten äußeren Rahmen (0113) und dem ersten inneren Rahmen (0111) vorhanden ist und sich das erste Stützteil (03) und das zweite Stützteil (0112) in unterschiedlichen Ausrichtungen des Reflektors (012) befinden.

10. Elektromagnetischer Mikrospiegel (11) nach Anspruch 9, wobei das bewegliche Teil (01) ferner eine zweite elektromagnetische Spule (014) umfasst, sich die zweite elektromagnetische Spule (014) auf dem ersten inneren Rahmen (0111) befindet und die zweite elektromagnetische Spule (014) dazu ausgelegt ist, den Reflektor (012) zur Bewegung anzutreiben;
das zweite Stützteil (0112) eine dritte Stützstruktur (01121) und eine vierte Stützstruktur (01122) umfasst, wobei sowohl die dritte Stützstruktur (01121) als auch die vierte Stützstruktur (01122) den ersten äußeren Rahmen (0113) mit dem ersten inneren Rahmen (0111) verbinden und die Steifigkeit der dritten Stützstruktur (01121) höher als die Steifigkeit der vierten Stützstruktur (01122) ist; und
Das befestigte Teil (02) ferner eine zweite Elektrode umfasst, die sich auf der befestigten Platte (021) befindet, wobei die vierte Stützstruktur (01122), der erste äußere Rahmen (0113) und die zweite Stützstruktur (032) einen zweiten Leitungsdraht aufweisen, der die zweite Elektrode mit der zweiten elektromagnetischen Spule (014) verbindet, und der zweite Leitungsdraht von dem ersten Leitungsdraht (033) isoliert ist.

11. Elektromagnetischer Mikrospiegel (11) nach Anspruch 10, wobei das zweite Stützteil (0112) beliebige der folgenden Bedingungen erfüllt:
das zweite Stützteil (0112) umfasst die dritte Stützstruktur und zwei Gruppen von vierten Stützstrukturen, die sich auf zwei Seiten der dritten Stützstruktur befinden; und
das zweite Stützteil (0112) umfasst die vierte Stützstruktur und zwei Gruppen von dritten Stützstrukturen, die sich auf zwei Seiten der vierten Stützstruktur befinden.

12. Elektromagnetischer Mikrospiegel (11) nach einem der Ansprüche 9 bis 11, wobei der elektromagnetische Mikrospiegel (11) zwei Gruppen von zweiten Stützteilen umfasst, die sich auf zwei gegenüberliegenden Seiten des Reflektors (012) befinden.

13. Elektromagnetischer Mikrospiegel (11) nach einem der Ansprüche 1 bis 12, wobei ein Leitungsdraht in dem elektromagnetischen Mikrospiegel (11) mindestens eine der folgenden Bedingungen erfüllt:
eine erste Isolationsschicht ist zwischen dem Leitungsdraht und einer Komponente, auf der sich der Leitungsdraht befindet, vorhanden; und
der Leitungsdraht umfasst mehrere parallel verbundene Unterdrähte, wobei orthographische Vorsprünge der mehreren Unterdrähte auf der Komponente, auf der sich der Leitungsdraht befindet, voneinander beabstandet sind; oder sich orthographische Vorsprünge der mehreren Unterdrähte auf der Komponente, auf der sich der Leitungsdraht befindet, zumindest teilweise überlappen und der Leitungsdraht ferner eine zweite Isolationsschicht umfasst, die sich zwischen den mehreren Unterdrähten befindet.

14. Elektromagnetischer Mikrospiegel (11) nach einem der Ansprüche 1 bis 12, wobei der elektromagnetische Mikrospiegel (11) mindestens eine der folgenden Bedingungen erfüllt:
Materialien der befestigten Platte (021), der ersten Stützstruktur (031), der zweiten Stützstruktur (032) und des Gerüsts (011) sind gleich; und
Materialien des Reflektors (012), eines Leitungsdrahts in dem elektromagnetischen Mikrospiegel (11) und einer Elektrode sind gleich.

## Revendications

1. Micromiroir électromagnétique (11), comprenant une partie mobile (01), une partie fixée (02) et une première partie de support (03), où
la partie mobile (01) comprend une armature (011), un réflecteur (012) et une première bobine électromagnétique (013) situés sur l'armature (01), où la première bobine électromagnétique est configurée pour entraîner en déplacement le réflecteur (012), et le réflecteur (012) présente une surface réfléchissante qui se retourne sur l'armature (011) ;
la partie fixée (02) comprend une plaque fixée (021) et une première électrode (022) située sur la plaque fixée (021) ; et
la première partie de support (03) comprend une première structure de support (031) et une deuxième structure de support (032) espacées l'une de l'autre, où à la fois la première structure de support (031) et la deuxième structure de support (032) relient l'armature (011) à la plaque fixée (021), la rigidité de la première structure de support (031) est supérieure à la rigidité de la deuxième structure de support (032), et la deuxième structure de support (032) dispose d'un premier fil routé (033) qui relie la première électrode (022) à la première bobine électromagnétique (013),
où la première partie de support (03) satisfait l'une quelconque des conditions suivantes :
la première partie de support (03) comprend la première structure de support et deux groupes de deuxièmes structures de support situés sur deux côtés de la première structure de support ; et
la première partie de support (03) comprend la deuxième structure de support et deux groupes de premières structures de support situés sur deux côtés de la deuxième structure de support.

2. Micromiroir électromagnétique (11) selon la revendication 1, dans lequel à la fois la première structure de support (031) et la deuxième structure de support (032) sont en forme de ligne, où une longueur équivalente de la première structure de support (031) est inférieure à une longueur équivalente de la deuxième structure de support (032), et une largeur équivalente de la première structure de support (031) est supérieure à une largeur équivalente de la deuxième structure de support (032).

3. Micromiroir électromagnétique (11) selon la revendication 2, dans lequel deux fois la longueur équivalente de la première structure de support (031) est inférieure à la longueur équivalente de la deuxième structure de support (032).

4. Micromiroir électromagnétique (11) selon l'une quelconque des revendications 1 à 3, dans lequel la première partie de support (03) satisfait au moins une des conditions suivantes :
la première structure de support (031) est de forme droite ; et
la deuxième structure de support (032) est en forme de serpentin.

5. Micromiroir électromagnétique (11) selon l'une quelconque des revendications 1 à 4, dans lequel les matériaux de la première structure de support (031), de la deuxième structure de support (032) et de l'armature (011) sont les mêmes.

6. Micromiroir électromagnétique (11) selon l'une quelconque des revendications 1 à 5, dans lequel la plaque fixée (021) a une pluralité de premières électrodes, la première partie de support (03) comprend une pluralité de deuxièmes structures de support qui sont en correspondance biunivoque avec la pluralité de premières électrodes, et des premiers fils routés sur les deuxièmes structures de support sont connectés aux premières électrodes correspondant aux deuxièmes structures de support.

7. Micromiroir électromagnétique (11) selon l'une quelconque des revendications 1 à 6, dans lequel le micromiroir électromagnétique (11) comprend deux groupes de premières parties de support situées sur deux côtés opposés du réflecteur (012).

8. Micromiroir électromagnétique (11) selon la revendication 7, dans lequel la partie fixée (02) comprend deux plaques fixées qui sont en correspondance biunivoque avec les deux groupes de premières parties de support ; et
pour une première partie de support d'un groupe de premières parties de support correspondant à une plaque fixée, la première partie de support est située entre la plaque fixée et le réflecteur (012), à la fois une première structure de support et une deuxième structure de support dans la première partie de support étant reliées à la plaque fixée, et un premier fil routé sur la deuxième structure de support est relié à une première électrode sur la plaque fixée.

9. Micromiroir électromagnétique (11) selon l'une quelconque des revendications 1 à 8, dans lequel l'armature (011) comprend un premier cadre intérieur (0111), une deuxième partie de support (0112), et un premier cadre extérieur (0113) ;
le premier cadre extérieur (0113) entoure le premier cadre intérieur (0111) et est espacé du premier cadre intérieur (0111), le réflecteur (012) est situé sur le premier cadre intérieur (0111), la première bobine électromagnétique (013) est située sur le premier cadre extérieur (0113), et la première partie de support (03) est reliée au premier cadre extérieur (0113) ; et
la deuxième partie de support (0112) est située entre le premier cadre extérieur (0113) et le premier cadre intérieur (0111), et relie le premier cadre extérieur (0113) au premier cadre intérieur (0111), une première zone creuse existe entre le premier cadre extérieur (0113) et le premier cadre intérieur (0111), et la première partie de support (03) et la deuxième partie de support (0112) sont situées dans différentes orientations du réflecteur (012).

10. Micromiroir électromagnétique (11) selon la revendication 9, dans lequel la partie mobile (01) comprend en outre une deuxième bobine électromagnétique (014), la deuxième bobine électromagnétique (014) est située sur le premier cadre intérieur (0111), et la deuxième bobine électromagnétique (014) est configurée pour entraîner le réflecteur (012) afin qu'il se déplace ;
la deuxième partie de support (0112) comprend une troisième structure de support (01121) et une quatrième structure de support (01122), à la fois la troisième structure de support (01121) et la quatrième structure de support (01122) relient le premier cadre extérieur (0113) au premier cadre intérieur (0111), et la rigidité de la troisième structure de support (01121) est supérieure à la rigidité de la quatrième structure de support (01122) ; et
la partie fixée (02) comprend en outre une deuxième électrode située sur la plaque fixée (021), la quatrième structure de support (01122), le premier cadre extérieur (0113) et la deuxième structure de support (032) possèdent un deuxième fil routé qui relie la deuxième électrode à la deuxième bobine électromagnétique (014), et le deuxième fil routé est isolé du premier fil routé (033).

11. Micromiroir électromagnétique (11) selon la revendication 10, dans lequel la deuxième partie de support (0112) satisfait l'une quelconque des conditions suivantes :
la deuxième partie de support (0112) comprend la troisième structure de support et deux groupes de quatrièmes structures de support situés sur deux côtés de la troisième structure de support ; et
la deuxième partie de support (0112) comprend la quatrième structure de support et deux groupes de troisièmes structures de support situés sur deux côtés de la quatrième structure de support.

12. Micromiroir électromagnétique (11) selon l'une quelconque des revendications 9 à 11, dans lequel le micromiroir électromagnétique (11) comprend deux groupes de deuxièmes parties de support situés sur deux côtés opposés du réflecteur (012).

13. Micromiroir électromagnétique (11) selon l'une quelconque des revendications 1 à 12, dans lequel un fil routé dans le micromiroir électromagnétique (11) satisfait au moins l'une des conditions suivantes :
une première couche isolante existe entre le fil routé et un composant sur lequel le fil routé est situé ; et
le fil routé comprend une pluralité de sous-fils connectés en parallèle, les projections orthogonales de la pluralité de sous-fils sur le composant sur lequel le fil routé est situé étant espacées les unes des autres ; ou les projections orthogonales de la pluralité de sous-fils sur le composant sur lequel le fil routé est situé se chevauchent au moins partiellement, et le fil routé comprend en outre une deuxième couche isolante située entre la pluralité de sous-fils.

14. Micromiroir électromagnétique (11) selon l'une quelconque des revendications 1 à 12, le micromiroir électromagnétique (11) satisfaisant au moins l'une des conditions suivantes :
les matériaux de la plaque fixée (021), de la première structure de support (031), de la deuxième structure de support (032) et de l'armature (011) sont les mêmes ; et
les matériaux du réflecteur (012), d'un fil routé dans le micromiroir électromagnétique (11) et d'une électrode sont les mêmes.
